# EUROPEAN PATENT SPECIFICATION

(11) **EP 4 113 747 B1**
(45) Date of publication and mention of the grant of the patent: **21.10.2026**
(21) Application number: 22191376.7
(22) Date of filing: 17.11.2020
(51) Int. Cl.: H01Q 3/22, G01S 7/03, G01S 13/42, H01Q 13/20

(54) **BEAM STEERING ANTENNA SYSTEMS AND METHODS THEREOF**
STRAHLLENKUNGSANTENNENSYSTEME UND VERFAHREN DAFÜR
SYSTÈMES D'ANTENNE À DIRECTION DE FAISCEAU ET PROCÉDÉS ASSOCIÉS

(43) Date of publication of application: 04.01.2023
(62) Document number(s) of the earlier application(s) in accordance with Art. 76 EPC: 20207959.6 / 4 001 956
(73) Proprietor: Stichting IMEC Nederland, 5656 AE Eindhoven (NL)
(72) Inventor: Visser, Huib, 5502 VK Veldhoven (NL); Hornung, Rainer Oliver, 5655 BG Eindhoven (NL); Dijkhuis, Johannes Frederik, 6537 DX Nijmegen (NL)
(74) Representative: Roth, Sebastian

(56) References cited:
- WO-A1-2007/057474
- US-A- 4 297 705
- US-A- 4 682 176
- US-A- 4 868 574
- US-B1- 7 924 170
- TOSPANN F-J ET AL: "MULTIFUNCTION 35 GHZ FMCW RADAR WITH FREQUENCY SCANNING ANTENNA FORSYNTHETIC VISION APPLICATIONS", PROCEEDINGS OF SPIE, IEEE, US, vol. 2463, 17 April 1995 (1995-04-17), pages 28 - 37, XP000198257, ISBN: 978-1-62841-730-2, DOI: 10.1117/12.212752

## Description

The invention relates to beam steering antenna systems, especially to frequency-scanned array antennas in compact radar applications in order to direct the antenna beam towards a target or a moving target without rotating the radar or said antennas.

Generally, in a frequency-scanned array antenna, the radiating elements are connected to one transmission line. The segments of the transmission line in-between the radiating elements realize the necessary phase shifts for pointing the antenna beam into the desired direction. Said phase shifts are frequency dependent since the length of the transmission line measured in wavelengths changes with frequency and the beam pointing direction will vary linearly with frequency.

However, the angular coverage or so-called scan range, i.e. the angular domain over which the antenna beam is required to be varied, is limited to a fraction of the hemisphere unless special techniques, such as serpentine feeding, are used to increase the line lengths in between the radiators. This limited angular coverage significantly restricts some radar applications, for instance radar applications surveilling the frontal region, since they require about double of the aforesaid angular coverage. One possible workaround is to use two frequency-scanned antenna arrays instead of one in order to increase the angular coverage. However, the implementation will be cost-intensive as well as impractical for applications that require smaller area.

Another possible workaround is to excite the antenna array from both sides sequentially. This is generally implemented by means of circulators as shown in the U.S. patent 4,297,705, for instance. However, a circulator is a non-reciprocal device consisting ferrite parts, which are subjected to a static magnetic field. Hence, permanent magnets are parts of a circulator, and therefore cannot be integrated in solid-state electronics. Moreover, having a plurality of circulators, e.g. for exciting the antenna array from both sides, leads to a larger size of the antenna array, which is also not practical for applications with area constraints. US application 4,868,574 discloses a similar antenna system.

Accordingly, an object of the invention is to provide beam steering antenna systems and methods for improving the angular coverage, especially to address the aforementioned limitations.

The object is solved by the features of the independent claim for the antenna systems and by the features of the second independent claim for the methods. The dependent claims contain further developments.

According to a first aspect of the invention, a beam steering antenna system for improving the angular coverage is provided. The antenna system comprises a transmission line comprising a first end and a second end. The antenna system further comprises a plurality of antenna elements coupled to the transmission line to couple energy within the transmission line to the plurality of antenna elements. Furthermore, the antenna system comprises a first power amplifier coupled to the first end of the transmission line configured to couple-in an input signal over a first time period of the input signal. Moreover, the antenna system comprises a second power amplifier coupled to the second end of the transmission line configured to couple-in the input signal over a second time period of the input signal. In this context, the first power amplifier and/or the second power amplifier are configured to provide an output impedance equal or close to a line impedance of the transmission line.

Therefore, the invention presents a solution for improving the angular coverage of a beam steering or frequency-scanned antenna array by exciting the antenna array from both sides, however without the necessity of having bulky circulators and/or complex switching arrangements. Hence, the proposed solution can be effectively implemented in solid-state electronics, while achieving a compact size for the antenna system.

Preferably, the antenna system further comprises control means configured to activate and/or deactivate the first power amplifier and/or the second power amplifier sequentially. In this regard, the control means is further configured to activate and/or deactivate the first power amplifier over the first time period of the input signal and wherein the control means is further configured to activate and/or deactivate the second power amplifier over the second time period of the input signal.

Preferably, in the case when the first power amplifier is activated and the second power amplifier is deactivated, the first power amplifier is configured to couple-in the input signal into the transmission line and the second power amplifier is configured to provide termination for the transmission line. Further preferably, in the case when the second power amplifier is activated and the first power amplifier is deactivated, the second power amplifier is configured to couple-in the input signal into the transmission line and the first power amplifier is configured to provide termination for the transmission line.

In this regard, the first power amplifier and/or the second power amplifier can be switched-on for the first operating period in order to couple-in the input signal into the transmission line and further can be switched-off for the second operating period in order to provide termination for the transmission line. In other words, the first power amplifier and/or the second power amplifier is configured to provide sufficient termination for the transmission line in order to couple-out any remaining energy of the input signal from the transmission when said power amplifier is switched-off.

According to a second aspect of the invention, a method for improving the angular coverage of a beam steering antenna system is provided. The method comprises the step of providing a transmission line comprising a first end and a second end. The method further comprises the step of selectively coupling a plurality of antenna elements onto the transmission line for selectively coupling energy within the transmission line to the plurality of antenna elements. Furthermore, the method comprises the step of coupling-in an input signal, by a first power amplifier coupled to the first end of the transmission line, over a first time period of the input signal.

Moreover, the method comprises the step of coupling-in the input signal, by a second power amplifier coupled to the second end of the transmission line, over a second time period of the input signal. In this context, the first power amplifier and/or the second power amplifier are configured to provide an output impedance equal or close to a line impedance of the transmission line. Hence, the proposed solution does not require bulky circulators and/or complex switching arrangements and therefore can be effectively implemented in solid-state electronics in a simple and cost-effective manner, while achieving a compact size for the antenna system.

Preferably, the method further comprises the step of activating and/or deactivating the first power amplifier over the first time period of the input signal. Additionally or alternatively, the method further comprises the step of activating and/or deactivating the second power amplifier over the second time period of the input signal. Further additionally or alternatively, the method comprises the step of activating and/or deactivating the first power amplifier and/or the second power amplifier sequentially.

For example, the first power amplifier can be configured to couple-in the input signal into the transmission line when the first power amplifier is switched-on, e.g. during the first operating period. Further, the first power amplifier can be configured to provide sufficient termination for the transmission line in order to couple-out any residual signal or energy of the input signal from the transmission line when the first power amplifier is switched-off, e.g. during the second operating period.

Analogously, the second power amplifier can be configured to couple-in the input signal into the transmission line when the second power amplifier is switched-on, e.g. during the second operating period. Further, the second power amplifier can be configured to provide sufficient termination for the transmission line in order to couple-out any residual signal or energy of the input signal from the transmission line when the second power amplifier is switched-off, e.g. during the first operating period. Exemplary embodiments of the invention and embodiments not covered by the claimed subject-matter but useful for understanding the invention are now further explained with respect to the drawings by way of example only, and not for limitation. In the drawings:
- Fig. 1: shows a first exemplary embodiment of the antenna system not covered by the claimed subject-matter according to an aspect;
- Fig. 2: shows a second exemplary embodiment of the antenna system not covered by the claimed subject-matter according to this aspect;
- Fig. 3: shows the proposed beam steering operation for the antenna system of Fig. 1 and Fig. 2;
- Fig. 4: shows a third exemplary embodiment of the antenna system not covered by the claimed subject-matter according to this aspect;
- Fig. 5: shows the proposed beam steering operation for the antenna system of Fig. 4;
- Fig. 6: shows an exemplary embodiment of the antenna system according to an aspect of the invention;
- Fig. 7: shows the proposed beam steering operation for the antenna system of Fig. 6;
- Fig. 8: shows an exemplary embodiment of the method not covered by the claimed subject-matter according to an aspect; and
- Fig. 9: shows an exemplary embodiment of the method according to an aspect of the invention.

Reference will now be made in detail to the embodiments of the present invention, examples of which are illustrated in the accompanying drawings. However, the following embodiments of the present invention may be variously modified and the range of the present invention is not limited by the following embodiments.

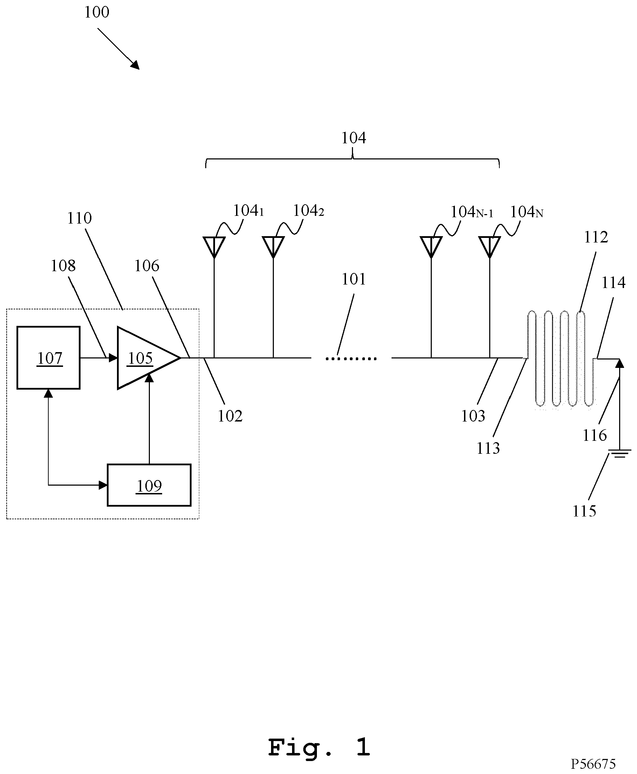

In Fig. 1, a first exemplary embodiment of the antenna system 100 according to an aspect of the invention is illustrated. The antenna system 100 comprises a transmission line 101 having a first end 102 and a second end 103. The antenna system comprises a number of N antenna elements 104 as shown herein with the individual antenna elements 104₁,104₂,...,104_{N-1},104_{N} that form an array of antenna elements 104 or a so-called antenna array. Said antenna array 104 is preferably implemented as a transmission line with radiating discontinuities realized in the same technology. Ideally, the antenna array 104 is designed such that when an input signal with a specific energy is fed at the first end 102 of the transmission line 101, about half the energy of the signal will be radiated by the antenna array 104. Therefore, at the second end 103 of the transmission line 101, a portion of the signal with about half the energy of the input signal will remain.

The antenna system 100 further comprises a power amplifier 105 having an output node 106, where the output node 106 is coupled to the first end 102 of the transmission line 101. The power amplifier 105 couples-in an input signal 108, e.g. a periodic chirp signal, with a time period T, preferably generated by a signal generator or chirp generator 107. A controller 109 is configured to switch-on or switch off the power amplifier 105, especially over specific time periods T of the input signal 108. Said switching-on or switching-off of the power amplifier 105 can be achieved, for example, by switching the power amplifier supply between a supply voltage VDD and the ground, respectively.

The controller 109 further communicates with the signal generator 107 in order to obtain information regarding the input signal 108, e.g. time, frequency, and the like, so as to control the on-time and the off-time of the power amplifier 105. The power amplifier 105, the signal generator 107 and the controller 109 can be integrated into a single chirp-generating unit 110 such as a radar chip (shown as a dashed box). When the power amplifier 105 is switched-off, the output node 106 of the power amplifier 105 provides an output impedance that matches or almost matches with the line impedance of the transmission line 101 (e.g. 50 ohm). Hence, the output impedance of the power amplifier 105 at the output node 106 acts as termination for the transmission line 101 when the power amplifier 105 is switched-off.

It is to be noted that, the controller 109 may not switch-off the power amplifier 105 completely, instead uses a bias to tune the output impedance. In this regard, the controller 109 may connect the drains of the transistors of the power amplifier 105 to ground, however, connects the gates of the transistors to a bias voltage in order to tune the output impedance at the output node 106.

The antenna system further includes a delay line, preferably a true-time-delay line (TTDL) 112 having a first port 113 and a second port 114. Said TTDL 112 further comprises a ground 115 connection at the second port 114 in order to provide a short circuit at the second port 114. The TTDL 112, especially the first port 113 of the TTDL 112 is coupled to the second end 103 of the transmission line 101. The TTDL 112 is configured to provide a delay equal to a half of the time period of the input signal 108. The TTDL 112 is preferably implemented as a micro-strip delay line, and hence if the antenna system 100 is realized as PCB-based micro-strip, the TTDL 112 can also be realized in the same technology and can be printed with the antenna array 104.

Therefore, for a first operating period, e.g. during the first period of the input signal 108, the controller 109 switches-on the power amplifier 105 and hence the power amplifier 105 couples-in the input signal 108 at the first end 102 of the transmission line 101. The antenna elements 104 radiate about half the energy of the input signal 108 and the remaining portion of the signal arrives at the second end 103 of the transmission line 101. At this point, the remaining signal is fed at the first port 113 of the TTDL 112 and is delayed by a half time period of the input signal 108 through the TTDL 112.

During a second operating period, e.g. during the second period of the input signal 108, the delayed signal portion is then reflected back as a reflection signal 116 at the second port 114 of the TTDL 112 due to the short circuit between the second port 114 and the ground 115. The reflection signal 116 is further delayed by a half period of the input signal 108 through the TTDL 112 and is coupled-in at the second end 103 of the transmission line 101. Hence, the TTDL 112 delays the reflection signal 116 by one time period of the input signal 108.

At this point, the antenna elements 104 radiate the energy of the reflection signal 116, while the controller switches-off, either completely or partially as mentioned above, the power amplifier 105, thereby providing termination for the reflection signal 116. Hence, if any remaining energy of the reflection signal 116 persists in the transmission line 101 after radiation, the switched-off power amplifier 105, especially the termination at the output node 106 will successfully couple-out the residual energy from the transmission line 101, thereby eliminating any further reflections in the opposite direction. Here, respective arrows indicate the signal directions.

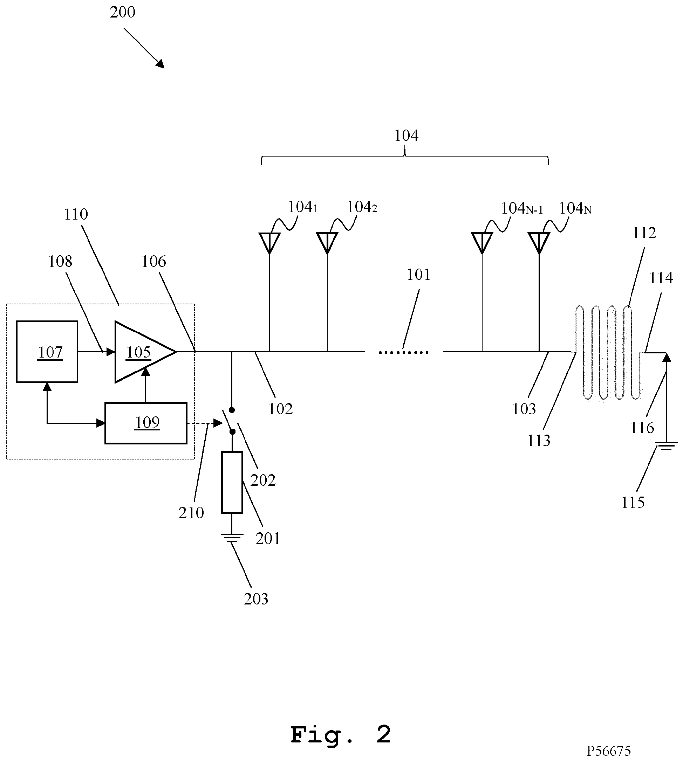

In Fig. 2, a second exemplary embodiment of the antenna system 200 according to an aspect of the invention is illustrated. The antenna system 200 differs from the antenna system 100 of Fig. 1 in that the antenna system 200 additionally comprises a dedicated termination arrangement. In this regard, a load resistor 201 is coupled between the output port 106 of the power amplifier 105 and the first end 102 of the transmission line 101 (i.e. parallel to the output of the power amplifier 105). Said load resistor 201 is coupled via a switch 202 to the output port 106 of the power amplifier 105 and is further connected to ground 203. The load resistor 201 is configured to provide an impedance equal to the line impedance of the transmission line 101.

The controller 109 operates the switch 202 via a control signal 210 to turn on or off the switch 202 so that the load resistor 201 will either be connected to the output port 106 of the power amplifier 105 or be disconnected, respectively. During the first operating period, the controller 109 switches-on the power amplifier 105 and turns-off the switch 202 (i.e. load resistor 201 disconnected). Hence, the input signal 108 is coupled into the transmission line 101 through the power amplifier 105. During the second operating period, the controller 109 switches-off the power amplifier 105, however, turns-on the switch 202 (i.e. the output port 106 is connected to ground 203 via the load resistor 201). This facilitates the load resistor 201 to act as termination for the reflection signal 116 as described above. The load resistor 201 therefore couples-out any remaining energy of the reflection signal 116 from the transmission line 101, thereby eliminating any further reflections in the opposite direction.

It is further possible to omit the switch 202 completely and to connect the load resistor 201 to the ground 203 permanently. This allows simpler implementation of said termination scheme. In addition to this or as an alternative, the load resistor 201 and the switch 202 can be replaced with a passive impedance matching network, for instance, LC networks, baluns, and so on, which can also be utilized to match the line impedance of the transmission line 101 and therefore acts as termination for the reflection signal 116. Advantageously, the output impedance requirements for the power amplifier 105 can be relaxed, which allows a more simplified implementation of the proposed solution.

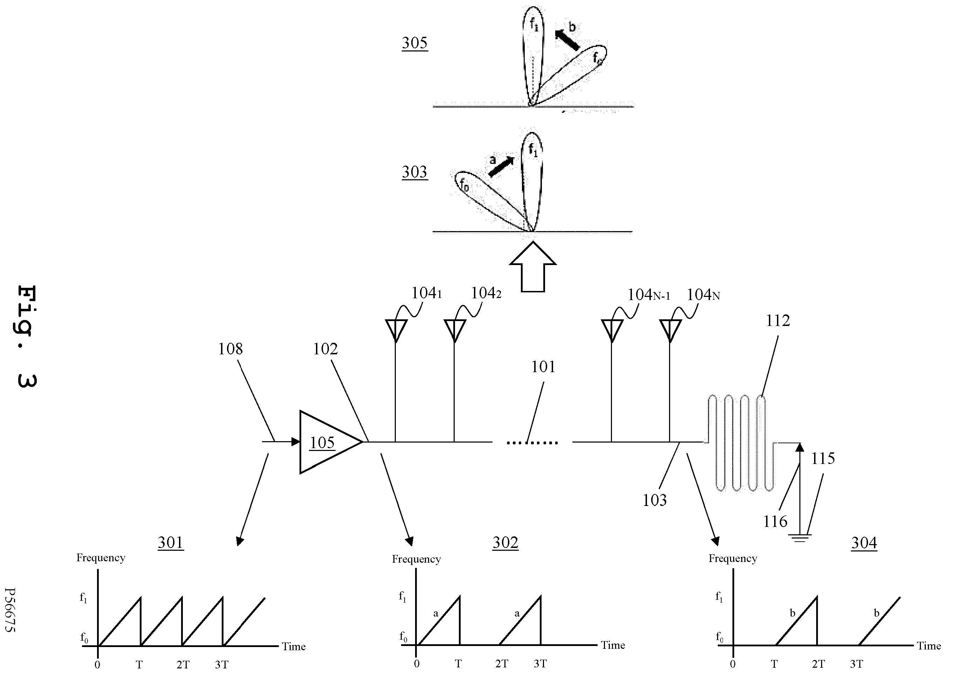

In Fig. 3, the proposed beam steering technique for the antenna system 100 and/or the antenna system 200 is illustrated. Generally, the signal generator 107 generates the input signal 108, as shown here as chirp signal 301 with a ramp or frequency sweep from a frequency f₀ to a frequency f₁ over a time 0 to T. The input signal 108 is periodic with a period T, i.e., a periodic repetition of frequency sweeps over a first period 0 to T, a second period T to 2T, and so on. The ramp or frequency sweep over the first period is labeled as "a" and the ramp or frequency sweep over the second period is labeled as "b", for example.

The power amplifier 105 is switched-on for the first period 0 to T of the input signal 108, resulting in the signal 302, which is coupled-in at the first end 102 of the transmission line 101. The antenna elements 104₁, 104₂,..., 104_{N-1}, 104_{N} selectively radiate the energy so that about half of the energy of the signal 302 present at the first end 102 of the transmission line 101 is dissipated. This result in the angular coverage depicted as 303. In other words, the antenna array is exited from the left via the ramp "a" of the signal 302, the beam position will change with frequency, i.e. going from a relative large angle with respect to broadside (perpendicular to the antenna array) at frequency f₀ to broadside at f₁.

The remaining signal is then fed to the TTDL 112, which delays the remaining signal by T/2 and the short circuit between the TTDL 112 and the ground 115 introduces the reflection signal 116 that is further delayed by T/2 by the TTDL 112. The signal present at the second end 103 of the transmission line 101 is shown as the signal 304, for instance. Hence, the signal 304 corresponds to the delayed version of the signal 302 with a delay of T. At this point, the signal 304 is fed to the second end 103 of the transmission line 101. The antenna elements 104₁,104₂,..., 104_{N-1},104_{N} analogously radiate the energy, which result in the angular coverage depicted as 305.

In other words, during the second operating period, the antenna array is exited from the right via the ramp "b" of the signal 304 and the beam position will change with frequency, i.e. going from a relative large angle with respect to broadside (perpendicular to the antenna array) at frequency f₀ to broadside at f₁. Any remaining energy of the reflection signal 116 will be coupled-out from the transmission line 101 by means of the termination techniques described above. Therefore, every first period of the input signal 108 ensures a scanning of the left part of the hemisphere 303 while every second period ensures a scanning of the right part of the hemisphere 305, thereby effectively doubling the angular coverage with respect to the conventional beam steering techniques.

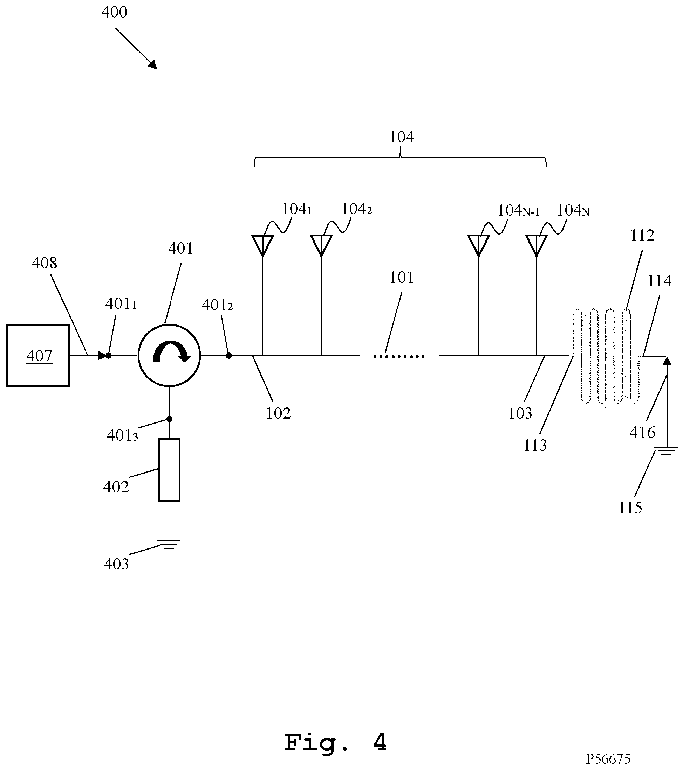

In Fig. 4, a third exemplary embodiment of the antenna system 400 according to the first aspect of the invention is illustrated. The antenna system 400 differs from the antenna system 100 of Fig. 1 in that the antenna system 400 comprises a circulator 401 that substitutes the switching-on and/or switching-off operation of the power amplifier 105 and additionally replaces the dedicated termination arrangement of the antenna system 200 of Fig. 2. The circulator 401 comprises a first node 401₁, a second node 401₂, and a third node 401₃. Therefore, energy going into the first port 401₁ exits at the second port 401₂, energy going into the second port 401₂ exits at the third port 401₃, and energy going into the third port 401₃ exits at the first port 401₁. However, the third port 401₃ is coupled to the ground 403 through a load resistor 402, which prevents energy flow from the third port 401₃ to the first port 401₁, while the load resistor 402 provides termination for the transmission line 101.

Moreover, the first port 401₁ of the circulator 401 is coupled to a signal generation unit 407, preferably comprising a signal generator and a power amplifier. The signal generation unit 407 may correspond to the chirp-generating unit 110 that comprises the signal generator 107, the power amplifier 105 and the controller 109, where the first port 401₁ of the circulator 401 is coupled to the output port 106 of the power amplifier 105. The signal generation unit 407 generates an input signal 408 and the second port 401₂ is coupled to the first end 102 of the transmission line 101. In this regard, the input signal 408 represents an upward ramp from a frequency f₀ to a frequency f₁ over a period 0 to T, however repeated over a period of 2T. Hence, the input signal 408 is present during the first operating period, and during the second operating period, no signal is present.

Therefore, during the first operating period, the circulator 401 couples-in the input signal 408 from the first port 401₁ to the second port 401₂ and further into the transmission line 101 through the first end 102. The antenna elements 104₁, 104₂,..., 104_{N-1}, 104_{N} radiate about half the energy of the input signal 408, which is present at the first end 102 of the transmission line 101, and the remaining portion of the signal arrives at the second end 103 of the transmission line 101. At this point, the remaining signal is fed at the first port 113 of the TTDL 112 and is delayed by a half time period of the input signal 408 through the TTDL 112.

During the second operating period, the delayed signal portion is then reflected back as a reflection signal 416 at the second port 114 of the TTDL 112 due to the short circuit between the second port 114 and the ground 115. The reflection signal 416 is further delayed by a half period of the input signal 408 through the TTDL 112 and is coupled-in at the second end 103 of the transmission line 101. Hence, the TTDL 112 delays the reflection signal 416 by one time period of the input signal 408.

At this point, the antenna elements 104₁, 104₂,..., 104_{N-1}, 104_{N} radiate the energy of the reflection signal 416. If any remaining energy of the reflection signal 416 persists in the transmission line 101 after radiation, the circulator 401, especially through the second port 401₂ and the third port 401₃, and further though the load resistor 402, will successfully couple-out the residual energy from the transmission line 101, thereby eliminating any further reflections in the opposite direction. Here, respective arrows indicate the signal directions.

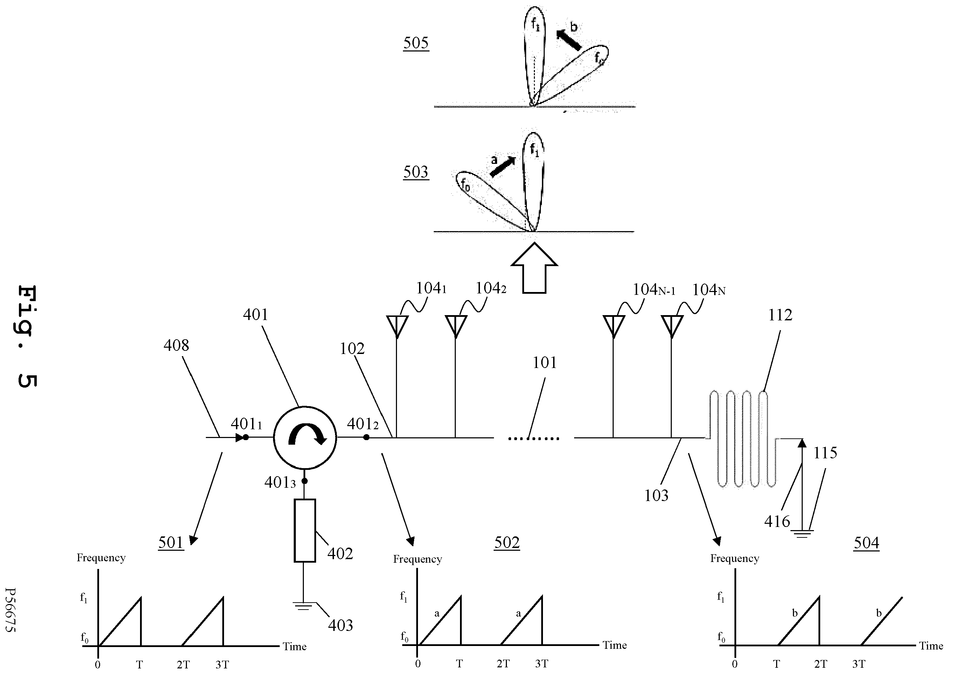

In Fig. 5, the proposed beam steering technique for the antenna system 400 is illustrated. The signal generation unit 407 generates the input signal 408, as shown here as chirp signal 501 with a ramp or frequency sweep from a frequency f₀ to a frequency f₁ over a time 0 to T and no frequency sweep over a time T to 2T. Hence, with respect to the input signal 408, the first operating period represents the period over the time 0 to T where the signal is present and the second operating period represents the period over a time T to 2T where no signal is present, and so on.

During the first operating period, the circulator 401 couples-in the input signal 408 at the first end 102 of the transmission line 101, which is shown as the signal 502 and the ramp is labelled as "a". The antenna elements 104₁,104₂,...,104_{N-1},104_{N} selectively radiate the energy so that about half of the energy of the input signal 408, i.e. the signal 501 resp. the signal 502 present at the first end 102 of the transmission line 101, is dissipated. This result in the angular coverage depicted as 503. In other words, the antenna array is exited from the left via the ramp "a" of the signal 502, the beam position will change with frequency, i.e. going from a relative large angle with respect to broadside (perpendicular to the antenna array) at frequency f₀ to broadside at f₁.

The remaining signal is then fed to the TTDL 112, which delays the remaining signal by T/2 and the short circuit between the TTDL 112 and the ground 115 introduces the reflection signal 416, which is further delayed by T/2 by the TTDL 112. The signal present at the second end 103 of the transmission line 101 is shown as the signal 504 and the ramp is labelled as "b", for instance. Hence, the signal 504 corresponds to the delayed version of the signal 502 with a delay of T. At this point, the signal 504 is fed to the second end 103 of the transmission line 101. The antenna elements 104₁, 104₂,..., 104_{N-1}, 104_{N} analogously radiate the energy, which result in the angular coverage depicted as 505.

In other words, during the second operating period, the antenna array is exited from the right via the ramp "b" of the signal 504 and the beam position will change with frequency, i.e. going from a relative large angle with respect to broadside (perpendicular to the antenna array) at frequency f₀ to broadside at f₁. Any remaining energy of the reflection signal 416 will be coupled-out from the transmission line 101 via the termination provided by the load resistor 402, coupled at the third port 401₃ of the circulator 401. Therefore, every first operating period ensures a scanning of the left part of the hemisphere 503 while every second operating period ensures a scanning of the right part of the hemisphere 505, thereby effectively doubling the angular coverage with respect to the conventional beam steering techniques.

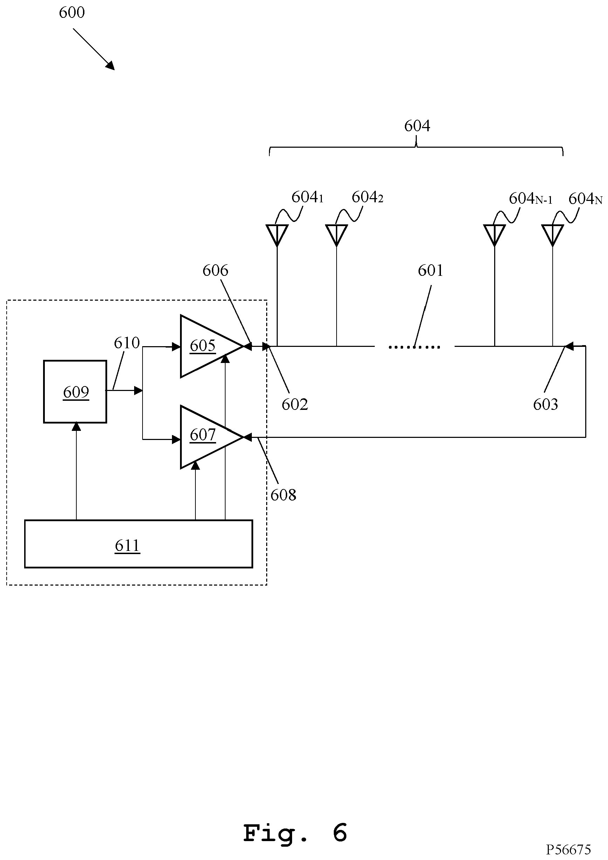

In Fig. 6, an exemplary embodiment of the antenna system 600 according to an aspect of the invention is illustrated. The antenna system 600 comprises a transmission line 601 having a first end 602 and a second end 603. The antenna system comprises a number of N antenna elements 604 as shown herein with the individual antenna elements 604₁, 604₂,..., 604_{N-1},604_{N} that form an array of antenna elements 604 or a so-called antenna array. Said antenna array 604 is preferably implemented as a transmission line with radiating discontinuities realized in the same technology. Ideally, the antenna array 604 is designed such that when an input signal with a specific energy is fed at the first end 602 of the transmission line 601, almost all the energy of the input signal will be radiated by the antenna array 604.

The antenna system 600 further comprises a first power amplifier 605 having an output node 606, where the output node 606 is coupled to the first end 602 of the transmission line 601. Moreover, the antenna system 600 comprises a second power amplifier 607 having an output node 608, where the output node 608 is coupled to the second end 603 of the transmission line 601. A signal generator 609 generates an input signal 610, which can be represented as a periodic chirp signal with a period of T. In this regard, a first period over the time 0 to T may correspond to a first operating period and a second period over the time T to 2T may correspond to a second operating period, and so on.

The antenna system 600 further comprises control means or controller 611, which is configured to switch-on or switch off the first power amplifier 605 and the second power amplifier 607, especially over specific time periods T of the input signal 610. Said switching-on or switching-off of the first power amplifier 605 and the second power amplifier 607 can be achieved, for example, by switching the power amplifier supply between a supply voltage VDD and ground, respectively. The control means 611 is preferably implemented with a sequential logic or a finite state machine.

The control means 611 further controls the signal generator 609 in order to synchronize the first power amplifier 605 and the second power amplifier 607 over the first operating period and the second operating period, respectively, or vice versa. In other words, the control means 611 controls the sequential operation of the first power amplifier 605 and the second power amplifier 607, i.e. turning-on and/or turning-off the first power amplifier 605 and the second power amplifier 607 sequentially, over the successive periods of operation, i.e. the successive periods of the input signal 610.

The first power amplifier 605, the second power amplifier 607, the signal generator 609, and the control means 611 can be integrated into a single chirp-generating unit such as a radar chip (shown as a dashed box).

When the first power amplifier 605 is switched-off, the output node 606 of the first power amplifier 605 provides an output impedance that matches or almost matches with the line impedance of the transmission line 601 (e.g. 50 ohm). Hence, the output impedance at the output node 606 acts as termination for the transmission line 601 when the power amplifier 605 is switched-off. Analogously, when the second power amplifier 607 is switched-off, the output node 608 of the second power amplifier 607 provides an output impedance that matches or almost matches with the line impedance of the transmission line 601 (e.g. 50 ohm). Hence, the output impedance at the output node 608 acts as termination for the transmission line 601 when the power amplifier 607 is switched-off.

It is to be noted that, the control means 611 may not switch-off the first power amplifier 605 and/or the second power amplifier 607 completely, instead uses a bias (e.g. bias current or bias voltage) to tune the output stage of the amplifier. In other words, the control means 611 may tune the biasing of the power amplifier, thereby tuning the output impedance of the amplifier in order to provide sufficient impedance matching with respect to the line impedance of the transmission line 601.

For example, for the first operating period, e.g. during the first period of the input signal 610, the control means 611 switches-on the first power amplifier 605 and switches-off the second power amplifier 607. Hence, the first power amplifier 605 couples-in the input signal 610 at the first end 602 of the transmission line 601 over the first period of the input signal 610. Preferably, the antenna elements 604 radiates almost all the energy of the input signal 610, resp. the energy of the signal present at the first end 602 of the transmission line 601. However, in practice, this is not the case and a portion of the energy from the input signal 610 persists in the transmission line 601. As a result, the remaining portion of the input signal 610 arrives at the second end 603 of the transmission line 601 and eventually terminated at the termination provided by the output impedance of the second power amplifier 607 at the output node 608.

For the second operating period, e.g. during the second period of the input signal 610, the control means 611 switches-off the first power amplifier 605 and switches-on the second power amplifier 607. Hence, the second power amplifier 607 couples-in the input signal 610 at the second end 603 of the transmission line 601 over the second period of the input signal 610. Preferably, the antenna elements 604 radiates almost all the energy of the input signal 610, resp. the energy of the signal present at the second end 603 of the transmission line 601. However, in practice, this is not the case and a portion of the energy from the input signal 610 persists in the transmission line 601. As a result, the remaining portion of the input signal 610 arrives at the first end 602 of the transmission line 601 and eventually terminated at the termination provided by the output impedance of the first power amplifier 605 at the output node 606. Here, respective arrows indicate the signal directions.

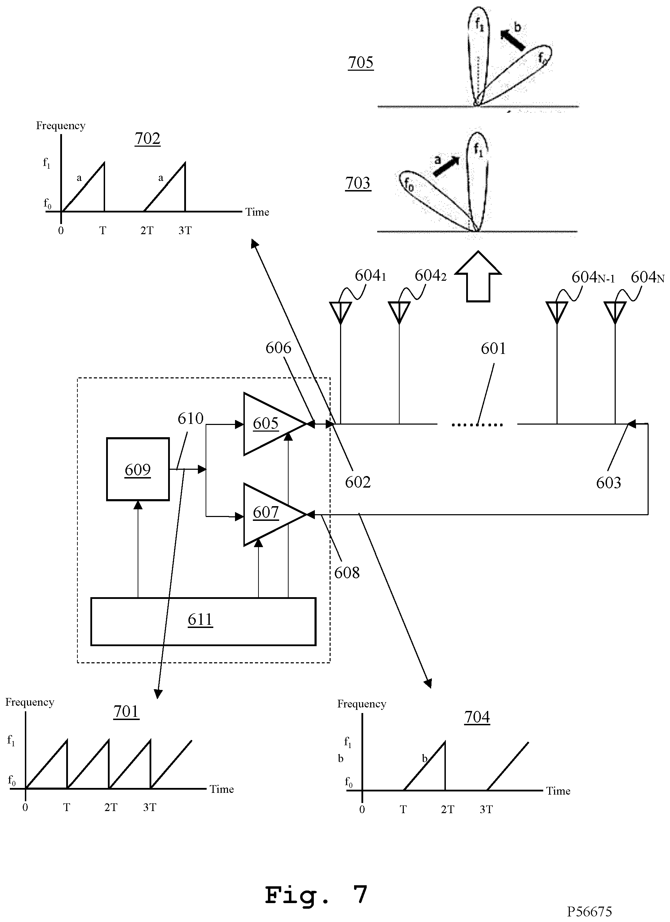

In Fig. 7, the proposed beam steering technique for the antenna system 600 is illustrated. Generally, the signal generator 609 generates the input signal 610, as shown here as chirp signal 701 with a ramp or frequency sweep from a frequency f₀ to a frequency f₁ over a time 0 to T. The input signal 610 is periodic with a period T, i.e., a periodic repetition of frequency sweeps over a first period 0 to T, a second period T to 2T, and so on. The ramp or frequency sweep over the first period is labeled as "a" and the ramp or frequency sweep over the second period is labeled as "b", for example.

For instance, consider the case where the first power amplifier 605 is switched-on and the second power amplifier 607 is switched-off for the first period 0 to T of the input signal 610. This result in the signal 702 at the output of the first power amplifier 605, which is coupled-in at the first end 602 of the transmission line 601 by the first power amplifier 605, while the second power amplifier 607 does not input any signal into the transmission line 601. The antenna elements 604₁, 604₂,..., 604_{N-1}, 604_{N} selectively radiate the energy, preferably the most of the energy of the signal 702 so that almost all of the energy is dissipated.

This result in the angular coverage depicted as 703. In other words, the antenna array is exited from the left via the ramp "a" of the signal 702, the beam position will change with frequency, i.e. going from a relative large angle with respect to broadside (perpendicular to the antenna array) at frequency f₀ to broadside at f₁. However, if there any residual energy persists in the transmission line 601, the remaining signal is then terminated at the second power amplifier 607, especially at the matched termination provided at the output node 608 of the second power amplifier 607.

Furthermore, consider the case where the first power amplifier 605 is switched-off and the second power amplifier 607 is switched-on for the second period T to 2T of the input signal 610. This result in the signal 704 at the output of the second power amplifier 607, which is coupled-in at the second end 603 of the transmission line 601 by the second power amplifier 607, while the first power amplifier 605 does not input any signal into the transmission line 601. The antenna elements 604₁,604₂,...,604_{N-1},604_{N} selectively radiate the energy, preferably the most of the energy of the signal 704 so that almost all of the energy is dissipated.

This result in the angular coverage depicted as 705. In other words, the antenna array is exited from the right via the ramp "b" of the signal 704, the beam position will change with frequency, i.e. going from a relative large angle with respect to broadside (perpendicular to the antenna array) at frequency f₀ to broadside at f₁. However, if there any residual energy of the persists in the transmission line 601, the remaining signal is then terminated at the first power amplifier 605, especially at the matched termination provided at the output node 606 of the first power amplifier 605.

Therefore, every first period of the input signal 610 ensures a scanning of the left part of the hemisphere 703 while every second period ensures a scanning of the right part of the hemisphere 705, thereby effectively doubling the angular coverage with respect to the conventional beam steering techniques.

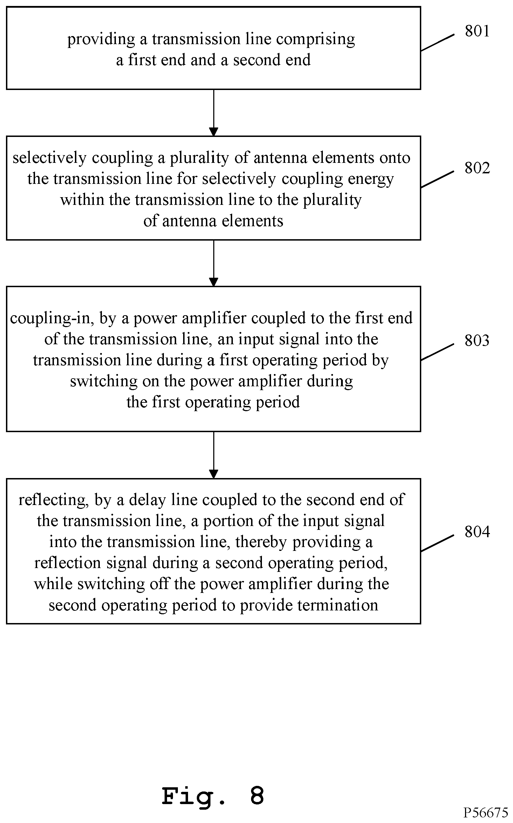

In Fig. 8, an exemplary embodiment of the method according to an aspect of the invention is illustrated. In a first step 801, a transmission line comprising a first end and a second end is provided. In a second step 802, a plurality of antenna elements are selectively coupled onto the transmission line for selectively coupling energy within the transmission line to the plurality of antenna elements. In a third step 803, an input signal is coupled-in into the transmission line by a power amplifier coupled to the first end of the transmission line during a first operating period, especially by switching-on the power amplifier during the first operating period. In a fourth step 804, a portion of the input signal is reflected into the transmission line by a delay line coupled to the second end of the transmission line, thereby providing a reflection signal during a second operating period, while the power amplifier is switched-off during the second operating period to provide termination for the transmission line.

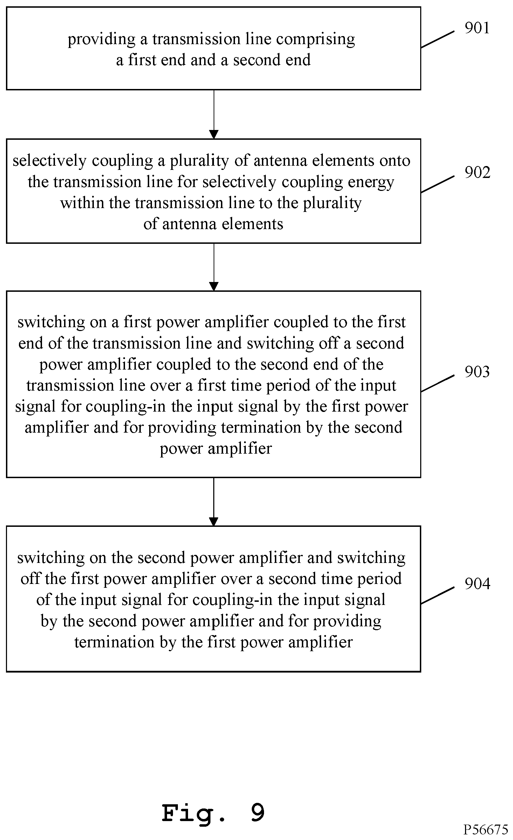

In Fig. 9, an exemplary embodiment of the method according to an aspect of the invention is illustrated. In a first step 901, a transmission line comprising a first end and a second end is provided. In a second step 902, a plurality of antenna elements are selectively coupled onto the transmission line for selectively coupling energy within the transmission line to the plurality of antenna elements. In a third step 903, a first power amplifier coupled to the first end of the transmission line is switched-on and a second power amplifier coupled to the second end of the transmission line is switched-off over a first time period of the input signal in order to couple-in the input signal into the transmission line by the first power amplifier and to provide termination for the transmission line by the second power amplifier. In a fourth step 904, the second power amplifier coupled to the second end of the transmission line is switched-on and the first power amplifier coupled to the first end of the transmission line is switched-off over a second time period of the input signal in order to couple-in the input signal into the transmission line by the second power amplifier and to provide termination for the transmission line by the first power amplifier.

The embodiments of the present invention can be implemented by hardware, software, or any combination thereof. Various embodiments of the present invention may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, or the like.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A beam steering antenna system (600) for improving the angular coverage of frequency-scanned array antennas, the antenna system comprising:
a transmission line (601) comprising a first end (602) and a second end (603),
a plurality of antenna elements (604) coupled to the transmission line (601) to couple energy within the transmission line (601) to the plurality of antenna elements (604),
a first power amplifier (605) coupled to the first end (602) of the transmission line (601) configured to couple-in an input signal (610) over a first time period of the input signal (610), and
a second power amplifier (607) coupled to the second end (603) of the transmission line (601) configured to couple-in the input signal (610) over a second time period of the input signal (610),
**characterized in that** the first power amplifier (605) and/or the second power amplifier (607) are configured to provide an output impedance equal or close to a line impedance of the transmission line (601).

2. The antenna system according to claim 1,
wherein the antenna system further comprises control means (611) configured to activate and/or deactivate the first power amplifier (605) and the second power amplifier (607) sequentially.

3. The antenna system according to claim 2,
wherein the input signal (610) is a periodic chirp signal, and
wherein the control means (611) is further configured to activate and/or deactivate the first power amplifier (605) over the first time period of the input signal (610) and wherein the control means (611) is further configured to activate and/or deactivate the second power amplifier (607) over the second time period of the input signal (610).

4. The antenna system according to any of claims 2 or 3, wherein the control means (611) is configured to activate the first power amplifier (605) and to deactivate the second power amplifier (607) during the first time period, whereby the first power amplifier (605) is configured to couple-in the input signal (610) into the transmission line (601) and the second power amplifier (607) is configured to provide termination for the transmission line (601).

5. The antenna system according to any of claims 2 or 3, wherein the control means (611) is configured to activate the second power amplifier (607) and to deactivate the first power amplifier (605) during the second time period, whereby the second power amplifier (607) is configured to couple-in the input signal (610) into the transmission line (601) and the first power amplifier (605) is configured to provide termination for the transmission line (601).

6. A method for improving the angular coverage of frequency-scanned array antennas by means of a beam steering antenna system (600), the method comprises the steps of:
providing a transmission line (601) comprising a first end (602) and a second end (603),
coupling a plurality of antenna elements (604) onto the transmission line (601) for coupling energy within the transmission line (601) to the plurality of antenna elements (604),
coupling-in an input signal (610), by a first power amplifier (605) coupled to the first end (602) of the transmission line (601), over a first time period of the input signal (610), and
coupling-in the input signal (610), by a second power amplifier (607) coupled to the second end (603) of the transmission line (601), over a second time period of the input signal (610),
**characterized in that** the first power amplifier (605) and/or the second power amplifier (607) are configured to provide an output impedance equal or close to a line impedance of the transmission line (601).

7. The method according to claim 6,
wherein the input signal (610) is a periodic chirp signal, and
wherein the method further comprises the steps of:
activating and/or deactivating the first power amplifier (605) over the first time period of the input signal (610), and/or
activating and/or deactivating the second power amplifier (607) over the second time period of the input signal (610), and/or
activating and/or deactivating the first power amplifier (605) and the second power amplifier (607) sequentially.

## Patentansprüche

1. Strahlablenkungs-Antennensystem (600) zum Verbessern der Winkelabdeckung von frequenzabgetasteten Array-Antennen, wobei das Antennensystem Folgendes umfasst:
eine Übertragungsleitung (601), die ein erstes Ende (602) und ein zweites Ende (603) umfasst,
mehrere Antennenelemente (604), die mit der Übertragungsleitung (601) gekoppelt sind, um Energie innerhalb der Übertragungsleitung (601) mit den mehreren Antennenelementen (604) zu koppeln,
einen ersten Leistungsverstärker (605), der mit dem ersten Ende (602) der Übertragungsleitung (601) gekoppelt ist und dazu ausgelegt ist, ein Eingangssignal (610) über eine erste Zeitdauer des Eingangssignals (610) einzukoppeln, und
einen zweiten Leistungsverstärker (607), der mit dem zweiten Ende (603) der Übertragungsleitung (601) gekoppelt ist und dazu ausgelegt ist, das Eingangssignal (610) über eine zweite Zeitdauer des Eingangssignals (610) einzukoppeln,
**dadurch gekennzeichnet, dass** der erste Leistungsverstärker (605) und/oder der zweite Leistungsverstärker (607) dazu ausgelegt sind, eine Ausgangsimpedanz gleich oder nahe einer Leitungsimpedanz der Übertragungsleitung (601) bereitzustellen.

2. Antennensystem nach Anspruch 1,
wobei das Antennensystem ferner ein Steuermittel (611) umfasst, das dazu ausgelegt sind, den ersten Leistungsverstärker (605) und den zweiten Leistungsverstärker (607) sequentiell zu aktivieren und/oder zu deaktivieren.

3. Antennensystem nach Anspruch 2,
wobei das Eingangssignal (610) ein periodisches Chirp-Signal ist und
wobei das Steuermittel (611) ferner dazu ausgelegt ist, den ersten Leistungsverstärker (605) über die erste Zeitdauer des Eingangssignals (610) zu aktivieren und/oder zu deaktivieren, und wobei das Steuermittel (611) ferner dazu ausgelegt ist, den zweiten Leistungsverstärker (607) über die zweite Zeitdauer des Eingangssignals (610) zu aktivieren und/oder zu deaktivieren.

4. Antennensystem nach einem der Ansprüche 2 oder 3, wobei das Steuermittel (611) dazu ausgelegt ist, während der ersten Zeitdauer den ersten Leistungsverstärker (605) zu aktivieren und den zweiten Leistungsverstärker (607) zu deaktivieren, wobei der erste Leistungsverstärker (605) dazu ausgelegt ist, das Eingangssignal (610) in die Übertragungsleitung (601) einzukoppeln, und wobei der zweite Leistungsverstärker (607) dazu ausgelegt ist, einen Abschluss für die Übertragungsleitung (601) bereitzustellen.

5. Antennensystem nach einem der Ansprüche 2 oder 3, wobei das Steuermittel (611) dazu ausgelegt ist, während der zweiten Zeitdauer den zweiten Leistungsverstärker (607) zu aktivieren und den ersten Leistungsverstärker (605) zu deaktivieren, wobei der zweite Leistungsverstärker (607) dazu ausgelegt ist, das Eingangssignal (610) in die Übertragungsleitung (601) einzukoppeln, und wobei der erste Leistungsverstärker (605) dazu ausgelegt ist, einen Abschluss für die Übertragungsleitung (601) bereitzustellen.

6. Verfahren zum Verbessern der Winkelabdeckung von frequenzabgetasteten Array-Antennen mittels eines Strahlablenkungs-Antennensystems (600), wobei das Verfahren die folgenden Schritte umfasst:
Bereitstellen einer Übertragungsleitung (601), die ein erstes Ende (602) und ein zweites Ende (603) umfasst,
Koppeln mehrerer Antennenelemente (604) an die Übertragungsleitung (601), um Energie innerhalb der Übertragungsleitung (601) mit den mehreren Antennenelementen (604) zu koppeln,
Einkoppeln eines Eingangssignals (610) durch einen ersten Leistungsverstärker (605), der mit dem ersten Ende (602) der Übertragungsleitung (601) gekoppelt ist, über eine erste Zeitdauer des Eingangssignals (610), und
Einkoppeln des Eingangssignals (610) durch einen zweiten Leistungsverstärker (607), der mit dem zweiten Ende (603) der Übertragungsleitung (601) gekoppelt ist, über eine zweite Zeitdauer des Eingangssignals (610),
**dadurch gekennzeichnet, dass** der erste Leistungsverstärker (605) und/oder der zweite Leistungsverstärker (607) dazu ausgelegt sind, eine Ausgangsimpedanz gleich oder nahe einer Leitungsimpedanz der Übertragungsleitung (601) bereitzustellen.

7. Verfahren nach Anspruch 6,
wobei das Eingangssignal (610) ein periodisches Chirp-Signal ist und
wobei das Verfahren ferner die folgenden Schritte umfasst:
Aktivieren und/oder Deaktivieren des ersten Leistungsverstärkers (605) über die erste Zeitdauer des Eingangssignals (610) und/oder
Aktivieren und/oder Deaktivieren des zweiten Leistungsverstärkers (607) über die zweite Zeitdauer des Eingangssignals (610) und/oder
Sequentielles Aktivieren und/oder Deaktivieren des ersten Leistungsverstärkers (605) und des zweiten Leistungsverstärkers (607).

## Revendications

1. Système antennaire à dépointage de faisceau (600) destiné à améliorer la couverture angulaire de réseaux d'antennes à balayage fréquentiel, le système antennaire comprenant :
une ligne de transmission (601) comprenant une première extrémité (602) et une deuxième extrémité (603),
une pluralité d'éléments d'antenne (604) couplés à la ligne de transmission (601) afin de coupler l'énergie présente dans la ligne de transmission (601) à la pluralité d'éléments d'antenne (604),
un premier amplificateur de puissance (605) couplé à la première extrémité (602) de la ligne de transmission (601), configuré pour coupler en entrée un signal d'entrée (610) pendant une première période de temps du signal d'entrée (610), et
un deuxième amplificateur de puissance (607) couplé à la deuxième extrémité (603) de la ligne de transmission (601), configuré pour coupler en entrée le signal d'entrée (610) pendant une deuxième période de temps du signal d'entrée (610),
**caractérisé en ce que** le premier amplificateur de puissance (605) et/ou le deuxième amplificateur de puissance (607) sont configurés pour fournir une impédance de sortie égale ou proche d'une impédance de ligne de la ligne de transmission (601).

2. Système antennaire selon la revendication 1,
le système antennaire comprenant en outre des moyens de commande (611) configurés pour activer et/ou désactiver séquentiellement le premier amplificateur de puissance (605) et le deuxième amplificateur de puissance (607).

3. Système antennaire selon la revendication 2,
dans lequel le signal d'entrée (610) est un signal chirp périodique, et
dans lequel les moyens de commande (611) sont en outre configurés pour activer et/ou désactiver le premier amplificateur de puissance (605) pendant la première période de temps du signal d'entrée (610) et dans lequel les moyens de commande (611) sont en outre configurés pour activer et/ou désactiver le deuxième amplificateur de puissance (607) pendant la deuxième période de temps du signal d'entrée (610).

4. Système antennaire selon l'une quelconque des revendications 2 ou 3,
dans lequel les moyens de commande (611) sont configurés pour activer le premier amplificateur de puissance (605) et pour désactiver le deuxième amplificateur de puissance (607) pendant la première période de temps, de sorte que le premier amplificateur de puissance (605) est configuré pour coupler en entrée le signal d'entrée (610) dans la ligne de transmission (601) et que le deuxième amplificateur de puissance (607) est configuré pour assurer une terminaison pour la ligne de transmission (601).

5. Système antennaire selon l'une quelconque des revendications 2 ou 3,
dans lequel les moyens de commande (611) sont configurés pour activer le deuxième amplificateur de puissance (607) et pour désactiver le premier amplificateur de puissance (605) pendant la deuxième période de temps, de sorte que le deuxième amplificateur de puissance (607) est configuré pour coupler en entrée le signal d'entrée (610) dans la ligne de transmission (601) et que le premier amplificateur de puissance (605) est configuré pour assurer une terminaison pour la ligne de transmission (601).

6. Procédé d'amélioration de la couverture angulaire de réseaux d'antennes à balayage fréquentiel au moyen d'un système antennaire à dépointage de faisceau (600), le procédé comprend les étapes suivantes :
fourniture d'une ligne de transmission (601) comprenant une première extrémité (602) et une deuxième extrémité (603),
couplage d'une pluralité d'éléments d'antenne (604) sur la ligne de transmission (601) pour coupler l'énergie présente dans la ligne de transmission (601) à la pluralité d'éléments d'antenne (604),
couplage en entrée d'un signal d'entrée (610), par un premier amplificateur de puissance (605) couplé à la première extrémité (602) de la ligne de transmission (601), pendant une première période de temps du signal d'entrée (610), et
couplage en entrée du signal d'entrée (610), par un deuxième amplificateur de puissance (607) couplé à la deuxième extrémité (603) de la ligne de transmission (601), pendant une deuxième période de temps du signal d'entrée (610),
**caractérisé en ce que** le premier amplificateur de puissance (605) et/ou le deuxième amplificateur de puissance (607) sont configurés pour fournir une impédance de sortie égale ou proche d'une impédance de ligne de la ligne de transmission (601).

7. Procédé selon la revendication 6,
dans lequel le signal d'entrée (610) est un signal chirp périodique, et
le procédé comprenant en outre les étapes suivantes :
activation et/ou désactivation du premier amplificateur de puissance (605) pendant la première période de temps du signal d'entrée (610), et/ou
activation et/ou désactivation du deuxième amplificateur de puissance (607) pendant la deuxième période de temps du signal d'entrée (610), et/ou
activation et/ou désactivation séquentielles du premier amplificateur de puissance (605) et du deuxième amplificateur de puissance (607).
